# EUROPEAN PATENT APPLICATION

(11) **EP 1 835 537 A1**
(43) Date of publication of application: **19.09.2007**
(21) Application number: 06425175.4
(22) Date of filing: 16.03.2006
(51) Int. Cl.: H01L 25/075, H01L 33/00

(54) **Light emission device and adjustment process for its chromaticity**

(71) Applicant: Centro Ricerche Plast-Optica S.r.l., 33020 Amaro (Udine) (IT)
(72) Inventor: Sinesi, Sabino, c/o Centro Richerche, 33020 Amaro (Udine) (IT); Rotaris, Gianluca, c/o Centro Richerche, 33020 Amaro (Udine) (IT); Padovani, Sara, c/o Centro Richerche, 33020 Amaro (Udine) (IT); Pairetti, Alberto, c/o Centro Richerche, 33020 Amaro (Udine) (IT)
(74) Representative: Marchitelli, Mauro

(57) **Abstract**

Described herein is a light-emission device, comprising one or more solid-state sources, obtained by positioning one or more light-emitting chips (13), which that emit light having a peak of emission at a first blue or ultraviolet wavelength (λ₁), on a substrate (11), said one or more light-emitting chips (13) being comprised in a protection package (15; 25; 15'; 15") for protection from agents together with converter elements (26; 36) for converting said light with a peak of emission at a first wavelength (λ₁), which have a spectrum of emission (S₂) capable of producing white light (L) in combination with said light having a peak of emission at a first blue or ultraviolet wavelength (λ₁). According to the invention, said device (10, 20) comprises in said package (15; 25; 15'; 15") one or more further light-emitting correction chips (23), which emit light having peak of emission corresponding to a third wavelength (λ₃) and are able to combine with said white light (L) emitted by said device (10; 20) to adjust its chromatic co-ordinates (x, y).

## Description

The present invention relates to a light-emission device comprising one or more solid-state sources, obtained by positioning on a substrate one or more light-emitting chips which emit light in the blue or in the ultraviolet, there being associated to said one or more light-emitting chips converter elements for converting said light to provide a white-light source.

In particular, reference will be made in what follows to provision of a multi-chromatic light source, in which one of the colours is white, by use of LED sources in the form of dies, or chip-LEDs, and wavelength-converter elements. By the term "chip-LED" is meant a multilayered semiconductor element that emits radiation if supplied. Said light-emitting chips are positioned directly on the printed circuit. Said light sources are moreover distinguished in that they are englobed in the same package, or casing, and hence enable use of the multi-chromatic source under a single lens.

It is known to produce light-emission devices using LEDs by coupling LEDs emitting blue light or else ultraviolet (UV) light with converter elements that convert the wavelength thereof to obtain an overall white-light source. One of the major problems in the construction of white LED sources of this sort lies in the need to resort subsequently to an operation of selection on the basis of the chromatic co-ordinates in categories referred to as "binning". In fact, the other than perfect control over the chromatic co-ordinates following upon minor differences in the intensity of the LED or in the percentage of converter elements brings about differences in the chromatic co-ordinates of the overall light emitted by said device. The purpose of the present invention is to solve said problem in a simple and effective way.

In order to achieve said purpose, the object of the invention is a light-emission device having the characteristics indicated in the annexed Claim 1. The object of the invention is also a process for adjustment of said light-emission device. Preferred embodiments of said device and process form the object of the subsequent dependent claims.

The invention will be now described with reference to the annexed drawings, which are provided purely by way of non-limiting example and in which:
- Figure 1 is a diagram illustrating the operation of the device according to the invention;
- Figure 2 is a schematic view of a device according to the invention;
- Figure 3 illustrates a second embodiment of the device according to the invention;
- Figure 4 illustrates further variants of the device according to the invention;
- Figure 5 illustrates a configuration of use of the device according to the invention; and
- Figure 6 illustrates a configuration of control of the device according to the invention.

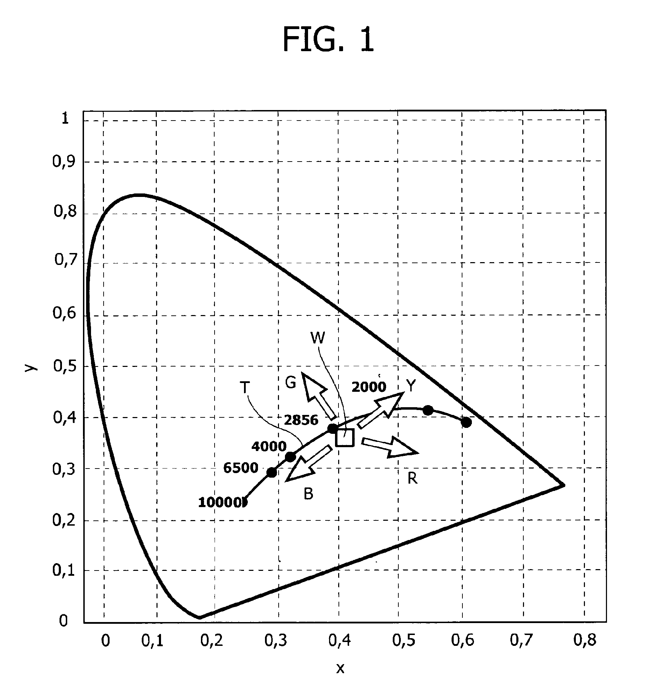

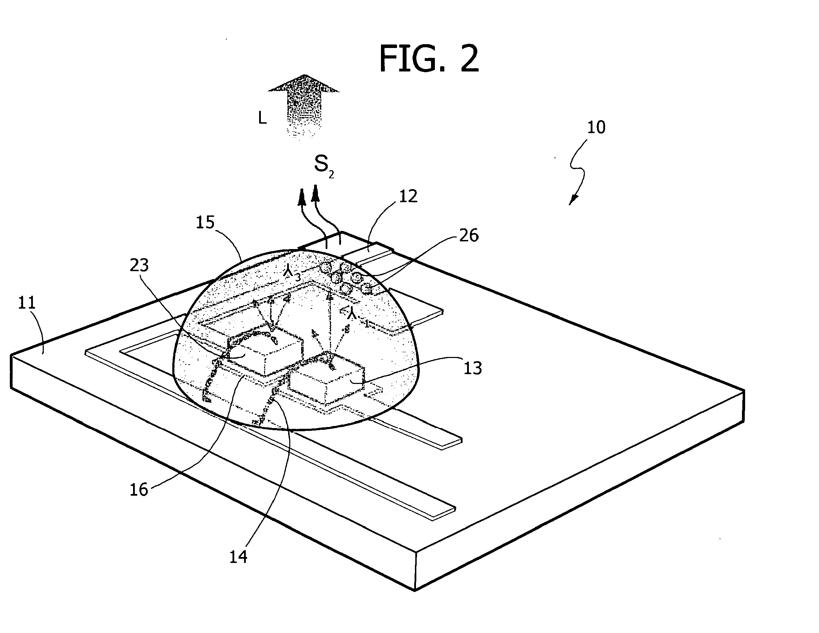

Figure 2 is a schematic and perspective view of a light source according to the invention, designated as a whole by the reference number 10. Said light source 10 comprises a substrate 11, in particular a printed circuit, which carries a plurality of conductive paths 12. Said conductive paths comprise suitableconductive pads 16. Bonded via a die-bonding process on one of said conductive pads 16 is a light-emitting chip 13 comprising light-emitting diodes (LEDs). Said light-emitting chip 13 emits a light having a spectrum, the peak of which is substantially localized around a first wavelength λ₁ in the region associated to the colour blue (430-490 nm). The reference number 14 designates an electrical-connection wire (wire-bonding operation) for carrying current to the LEDs. Set on the substrate 11 alongside said light-emitting chip 13 is a second correction chip 23, which emits a light the peak of which is substantially localized around a second wavelength λ₃, which is used hereinafter as identifier of the red region, but which can belong to the green, yellow or red regions (520-700 nm), as will be described in greater detail hereinafter in the description of Figure 1. Said second correction chip 23 is set on a corresponding pad 16 and is supplied by a respective electrical-connection wire 14 associated thereto.

As may be noted from Figure 2, the blue chip 13 and the correction chip 23 are coated during the packaging operation by a so-called "glob-top" 15, i.e., a substantially dome-shaped resin package, which, in addition to ensuring protection of the chip 13 from any possible external agents, also performs optical functions. Various types of resins and plastic materials can be used for packaging, for example epoxy resins or acrylate resins or organic-inorganic hybrid materials. In particular, the glob-top 15 contains a dispersion of wavelength-converter elements 26 (also shown only very partially in Figure 2 for simplicity) designed to interact with the light emitted at a first wavelength λ₁ by the light-emitting chip 13 in order to give rise to a light with a spectrum of emission S₂. Said converter elements are not, instead, excited by the wavelength λ₃ of the light-emitting correction chip. Consequently, said dispersion of wavelength-converter elements 26 is stimulated only by the light emitted by the chip 13. The combination of a fraction of the light at a first wavelength, blue (or UV), with the light with spectrum S₂ re-emitted by the dispersion of converter elements 26 under the stimulus of another fraction of the light at a first wavelength, i.e., blue, produces in itself white light, which, however, undergoes fine correction in its chromatic co-ordinates via the light at the third wavelength, for example red, produced by the correction chip 23 so as to produce an overall light emitted by the device 10 outside the package 15 that is white, with its chromatic co-ordinates adjusted.

Hence, the device 10 shown in Figure 2 illustrates the use of two or more chip-LEDs, at least one of which is blue (or UV), and which are englobed in a package made of resin containing wavelength-converter elements.

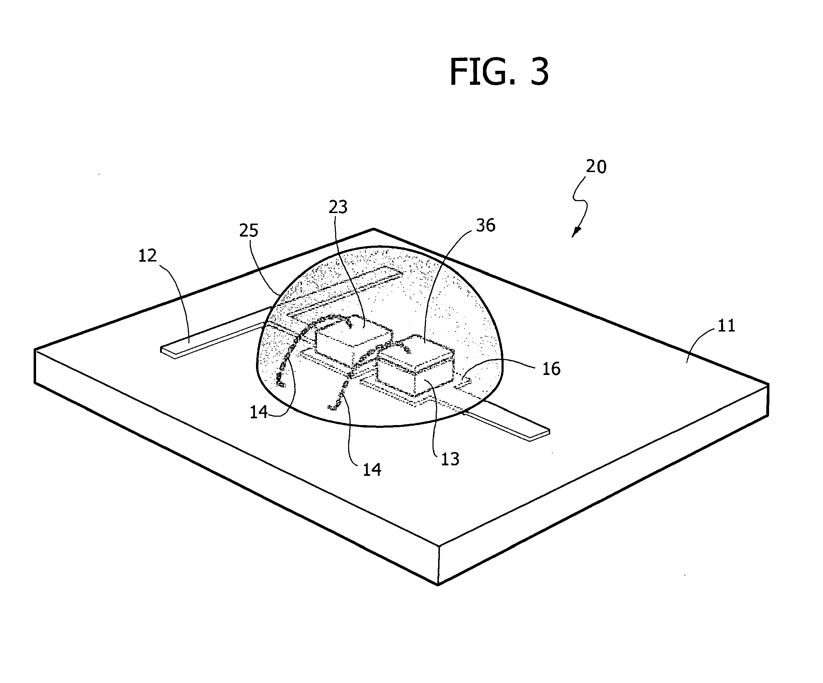

Figure 3 represents an alternative embodiment of a device 20, which comprises a similar arrangement of the blue (or UV) chips 13 and of the correction chips 23 underneath a transparent glob-top 25, which, consequently, does not contain inside it converter elements like the glob-top 15 shown in Figure 2. A thin film 36 of converter elements is, instead, deposited directly on the top surface of the blue (or UV) chips 13.

The converter elements represented by the dispersion 26 in the glob-top 25 and by the thin film 36 must be able to convert part of the blue light (430-490 nm) (or UV light (300-420 nm)) into light with a spectrum such as to generate white light if combined to the non-converted fraction of blue (or UV) light. The dispersion 26 and the thin film 36 can comprise yellow inorganic phosphors such as, for example, (Y, Gd) 3A15O12:Ce or Sr2SiO4:Eu, or else semiconductor quantum dots such as CdSe, CdS. In the case where the first wavelength λ₁ is in the ultraviolet, combinations of RGB phosphors may be used. Said converter elements must be designed appropriately in order to obtain a white source from the blue (or UV) chip-LED 13.

In the device 20 of Figure 3, as light-emitting correction chip 23, chip-LEDs from green to red (520-700 nm) can be used without the presence of the converter elements affecting the chromatic co-ordinates, in so far as an excitation of the phosphors of the film 36 at the second wavelength λ₃ is not envisaged.

In the device 20 of Figure 3, the thin film 36 can be obtained via thermal evaporation, techniques of plasma deposition, etc.

The devices 10 and 20 of Figure 2 and 3 can be obtained with the chip-on-board technology, which comprises the following steps:
a. preparation of the substrate 11 with the metal pads 16 for positioning the chip-LEDs (dies) 13, 23;
b. pick-and-place operation for positioning of the dies 13, 23 on the respective metal pad 16;
c. constraining of the die 13, 23, or die-attach, using conductive resin;
d. wire bonding via the connections 14 between the electrodes of each individual die 13, 23 and the respective pads 16; and
e. protective coating with resin package 15 containing wavelength-converter elements 26 as shown in Figure 2, or else deposition of the thin film 36 on the blue (or UV) chip-LEDs and subsequent coating with glob-top 25 made of transparent resin as shown in Figure 3.

An alternative to the wire-bonding process can be the solution of the flip-chip technique, in which, using dies with horizontal electrodes, the connections with the pads 16 of the substrate 11 can be made using metal balls, flipping the die over, and guaranteeing the pad-electrode contact. The flip-chip solution is recommended in the case where it is necessary to deposit the thin film 36 of converter elements to obtain the device 20 of Figure 3.

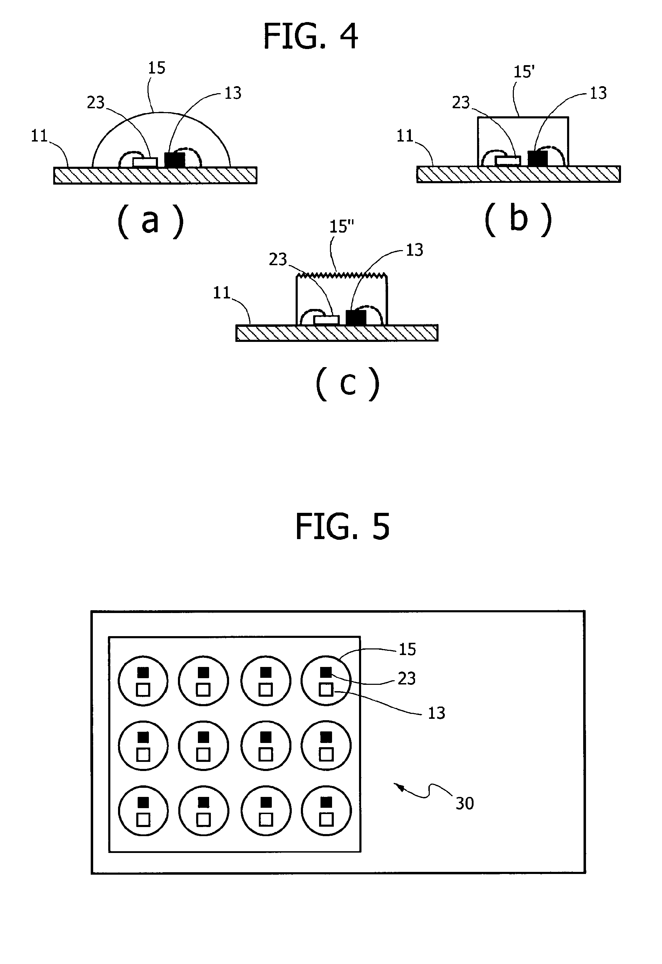

Figures 4a, 4b and 4c show packages of different shapes and dimensions. Figure 4b shows a side view of a glob-top 15' of a cylindrical type. Figure 4a shows a side view of the dome-shaped glob-top 15 of Figure 2, whilst Figure 4c shows a glob-top 15'' having a cylindrical shape, which present on the top base for output of the light L integrated micro-optics, i.e., surface micro-structures, for example, microprisms, to obtain a better merging of the colour, above all in the case where there are a number of light-emitting chips.

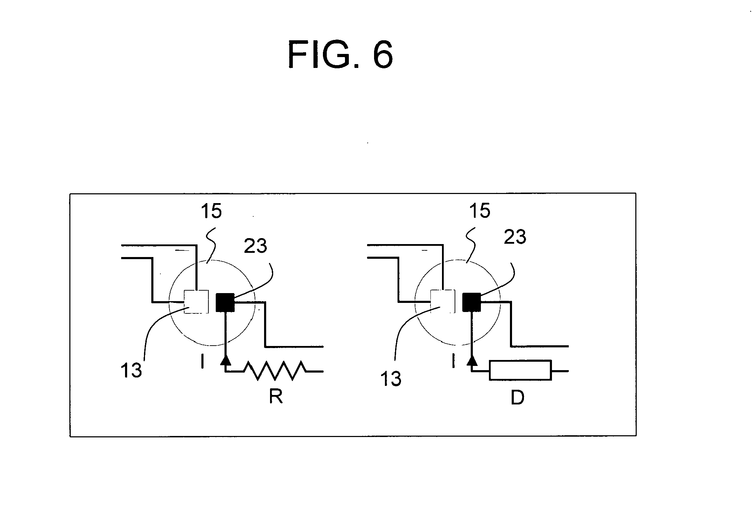

Figure 6 shows a possible configuration of use of the devices 10 and/or 20, which use the multi-chromatic sources to provide a matrix array 30 of devices 10, which constitute white sources with exact chromatic co-ordinates. In fact, as shown in Figure 6, each white source represented by a light-emitting chip 13 associated to conversion elements present in the package 15 is coupled to one or more coloured sources, represented by the correction chips 23, which are used for rendering the chromatic co-ordinates of white uniform.

Figures 6a and 6b show two different ways for controlling adjustment of the chromatic co-ordinates through control of the intensity of the light emitted by the correction chips 23. The correction chip-LEDs can be driven individually by passive elements, for example, as in Figure 6a, via a purposely provided adjustable resistance R, which determines the value of a current I sent to the light-emitting correction chip 23, or else, as shown in Figure 6b, via active elements, i.e., a driver D for current driving, in order to obtain for each individual source the desired chromatic co-ordinates.

For a better understanding, Figure 1 illustrates a diagram of the chromatic co-ordinates x and y in which it is shown how, starting from a white source, identified by the colour point W (white square), it is possible to modify the chromatic co-ordinates adding a coloured component. The arrows indicate the direction in which the colour point W is displaced by adding a green component G, or a red component R, or a yellow component Y, or else a blue component B. It may be noted that the blue component B can be added to perform correction when the light-emitting chip 13 emits in the region of ultraviolet wavelengths. Likewise appearing in Figure 1 a curve of colour temperature T for reference.

From the above description the advantages of the device and process proposed herein emerge clearly.

Advantageously, the present invention affords a solution for obtaining multi-chromatic LED sources, in which one of the colours is white, which does not require any operations of selection subsequent to production, the chromatic co-ordinates being adjustable through an adjustment of the intensity of a coloured correction die set alongside the die that emits blue or UV radiation. This moreover advantageously enables variation with continuity of the chromatic co-ordinates of the white light.

It may be noted that, whereas bi-chromatic or multi-chromatic LED sources are already present in the known art, solutions that envisage provision of sources that correct the chromatic co-ordinates of a source mediated by a wavelength conversion, in particular a source that emits overall white light, are not known.

The device according to the invention can be advantageously applied in particular in the automotive sector, in so far as it may be used to provide front or rear signalling functions (position lights, stop lights, direction lights, and reversing lights) using bi-chromatic or multi-chromatic sources, and hence having the possibility of providing different functions by means of a single array of LEDs, affording a higher number of styling possibilities.

The device according to the invention can also be applied, however, to the advertising sector, to the sector for providing public information, and to lighting in general, the latter being a field in which the capacity for modifying the chromatic co-ordinates is of particular interest.

Of course, without prejudice to the principle of the invention, the details of construction and the embodiments may vary widely with respect to what is described and illustrated herein purely by way of example, without thereby departing from the scope of the present invention.

## Claims

1. A light-emission device (10, 20), comprising one or more solid-state sources, obtained by positioning on a substrate (11) one or more light-emitting chips (13) that emit light having a peak of emission at a first blue or ultraviolet wavelength (λ1) , said one or more light-emitting chips (13) being comprised in a protection package (15; 25; 15'; 15") for protection from agents, together with converter elements (26; 36) for converting said light with a peak of emission at a first wavelength (λ₁), which have a spectrum of emission (S₂) capable of producing white light (L) in combination with said light having a peak of emission at a first blue or ultraviolet wavelength (λ₁), **characterized in that** said device (10, 20) comprises in said package (15; 25; 15'; 15") one or more further light-emitting correction chips (23) that emit light, which has a peak of emission corresponding to a third wavelength (λ₃) and suitable for combining with said white light (L) emitted by said device (10; 20) to adjust its chromatic co-ordinates (x, y).

2. The light-emission device according to Claim 1, **characterized in that** said spectrum of emission (S₂) capable of producing white light (L) in combination with said light having a peak of emission at a first wavelength (λ₁) is localized in the yellow region.

3. The light-emission device according to Claim 1, **characterized in that** said spectrum of emission (S₂) capable of producing white light (L) in combination with said light having a peak of emission at a first wavelength (λ₁) corresponds to the spectral emissions of RGB phosphors.

4. The light-emission device according to Claim 1 or Claim 2, **characterized in that** said first wavelength (λ₁) is localized in the region of wavelengths of blue and said third wavelength (λ₃) is localized in the region of wavelengths of yellow (Y) or red (R) or green (G).

5. The light-emission device according to Claim 1 or Claim 3, **characterized in that** said first wavelength (λ₁) is localized in the region of wavelengths of ultraviolet and said third wavelength (λ₃) is localized in the region of wavelengths of yellow (Y) or red (R) or green (G) or blue (B).

6. The light-emission device according to one or more of the preceding Claims 1 to 5, **characterized in that** it comprises means (R; D) for adjusting the intensity of the light emitted by said one or more further light-emitting correction chips (23) that emit light with peak of emission at a third wavelength (λ₃).

7. The light-emission device according to one or more of the preceding Claims 1 to 6, **characterized in that** said means for adjusting the intensity of the light emitted comprise an adjustment resistance (R).

8. The light-emission device according to one or more of the preceding Claims 1 to 6, **characterized in that** said means for adjusting the intensity of the light emitted comprise an active driver circuit (D) for driving said one or more further light-emitting chips (23).

9. The light-emission device according to one or more of the preceding Claims 1 to 8, **characterized in that** said converter elements (26) comprise a distribution of elements within said package (15, 15', 15") for protection from agents deposited on said one or more light-emitting chips (13) and on said one or more light-emitting correction chips (23).

10. The light-emission device according to one or more of the preceding Claims 1 to 7, **characterized in that** said converter elements (36) comprise a conversion thin film deposited on said one or more light-emitting chips (13) that emit light having a first peak of emission at a first wavelength (λ₁).

11. The light-emission device according to Claim 9 or Claim 10, **characterized in that** said dispersion (26) or said thin film (36) comprises phosphors.

12. The light-emission device according to Claim 11 or Claim 12, **characterized in that** said dispersion (26) or said thin film (36) comprises semiconductor quantum dots.

13. The light-emission device according to one or more of the preceding Claims 1 to 12, **characterized in that** said chips (13, 23) are integrated in the form of dies.

14. The light-emission device according to Claim 13, **characterized in that** it is fabricated by means of processes of the chip-on-board type.

15. The light-emission device according to Claim 14, **characterized in that** the die connections can be obtained by wire bonding or by the flip-chip technique.

16. The light-emission device according to one or more of the preceding Claims 13 to 15, **characterized in that** said one or more light-emitting chips (13) and correction chips (23) are comprised within a single package (15; 15'; 15" ; 25).

17. The light-emission device according to one or more of the preceding Claims 13 to 16, **characterized in that** said one or more light-emitting chips (13) and correction chips (23) are comprised under a single lens.

18. The light-emission device according to one or more of Claims 1 to 17, **characterized in that** said one or more light-emitting chips (13) and correction chips (23) are arranged to form a matrix array (30) of white sources with chromatic co-ordinates (x, y) that can be adjusted individually by means of passive adjustment elements (R) or active adjustment elements (D).

19. The light-emission device according to one or more of Claims 1 to 18, **characterized in that** said package (15; 25) is dome-shaped.

20. The light-emission device according to one or more of Claims 1 to 18, **characterized in that** said package (15'; 15") is cylindrical.

21. The light-emission device according to Claim 20, **characterized in that** said package (15'') comprises micro-optics for merging the colour.

22. A process for adjustment of the chromatic co-ordinates of a light-emission device (10; 20), which comprises the operations of emitting via one or more light-emitting chips (13) light having a peak of emission at a first blue or ultraviolet wavelength (λ₁) and converting (26; 36) said light into light having a spectrum of emission (S₂) such as to determine white light (L) in combination with said light having a peak of emission at a first blue or ultraviolet wavelength (λ₁), said process being **characterized in that** it comprises the operations of:
- emitting light having a peak of emission at a third wavelength (λ₃) via one or more further light-emitting correction chips (23); and
- correcting chromatic components (x, y) of the white light (L) emitted by the device (10; 20; 30) via control of the intensity for converting said light having a peak of emission at a third wavelength (λ₃).

23. The process according to Claim 22, **characterized in that** said spectrum of emission (S₂) capable of producing white light (L) in combination with said light having a peak of emission at a first wavelength (λ₁) is localized in the region of yellow.

24. The process according to Claim 22, **characterized in that** said spectrum of emission (S₂) capable of producing white light (L) in combination with said light having a peak of emission at a first wavelength (λ₁) corresponds to the spectral emissions of RGB phosphors.

25. The process according to Claim 23, **characterized in that** said first wavelength (λ₁) is localized in the region of wavelengths of blue and said third peak of emission is localized in the region of wavelengths of yellow (Y) or red (R) or green (G).

26. The process according to Claim 24, **characterized in that** said first wavelength (λ₁) is localized in the region of wavelengths of ultraviolet and said third peak of emission is localized in the region of wavelengths of yellow (Y) or red (R) or green (G) or blue (B).

27. The process according to one or more of the preceding Claims 21 to 26, **characterized in that** said operation of controlling the intensity of light emitted by one or more further light-emitting correction chips (23) comprises operating on an adjustment resistance (R).

28. The process according to one or more of the preceding Claims 21 to 27, **characterized in that** said operation of controlling the intensity of light emitted by one or more further light-emitting correction chips (23) comprises operating via an active driver circuit (D) for driving said one or more further light-emitting chips (23).
